(19) Europäisches Patentamt
European Patent Office
Office européen des brevets

(11) **EP 3 216 894 A1**

(12) **EUROPEAN PATENT APPLICATION**

(43) Date of publication:
**13.09.2017 Bulletin 2017/37**

(51) Int Cl.:
***C23C 14/06*** (2006.01)      ***C23C 14/34*** (2006.01)
***H01L 41/187*** (2006.01)      ***H01L 41/316*** (2013.01)

(21) Application number: **17160064.6**

(22) Date of filing: **09.03.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **09.03.2016 US 201615064989**

(71) Applicant: **Teledyne Dalsa Semiconductor Inc. Bromont, QC J2L 1S7 (CA)**

(72) Inventors:
• DAOUST, Patrick
  **Montreal, Québec H2A 1G9 (CA)**
• COIA, Cedrik
  **Brossard, Québec J4W 2R4 (CA)**
• DESJARDINS, Patrick
  **St-Laurent, Québec H4R 3C4 (CA)**
• MASUT, Remo
  **Montreal, Québec H3W 2G1 (CA)**

(74) Representative: **Keane, David Colman**
  **Murgitroyd & Company**
  **Scotland House**
  **165-169 Scotland Street**
  **Glasgow G5 8PL (GB)**

(54) **PIEZOELECTRIC ALLOY FILMS**

(57)     A thin film $X_yAl_{(1-y)}N$ alloy preferably deposited with an intrinsic tensile stress significantly enhances the piezoelectric properties of AlN. The alloy contains y percent of the compound XN, where X is selected from the group consisting of Yb, Ho, Dy, Lu, Tm, Tb, and Gd. The percentage of XN preferably lies in the range 10-60%, and the stress is preferably in the range 200MPa - 1.5GPa. The film is useful in MEMS devices.

**Fig. 4**

EP 3 216 894 A1

## Description

Field of the Invention

This invention relates to the field of piezoelectric alloy films, and more particularly to piezoelectric films suitable for use in micro-electromechanical systems (MEMS) devices.

Background of the Invention

Historically, piezoelectric films have relied on the use of lead, typically in the form of lead zirconate titanate (PZT), which is undesirable for environmental reasons. Lead-free intrinsic piezoelectric films that can be easily manufactured and integrated in MEMS manufacturing processes, such as aluminum nitride, do not have sufficiently high piezoelectric coefficients for use in many potential piezoelectric device applications.

A technology consortium based in Japan demonstrated that the inclusion of elemental scandium in aluminum nitride by reactive co-sputtering to form an $Al_{0.57}Sc_{0.43}N$ sputtered alloy gives a piezoelectric coefficient $d_{33}$ of about 25pm/V. (Akiyama, M et al Enhancement of Piezoelectric Response in Scandium Aluminum Nitride Alloy Thin Films Prepared by Dual Reactive Co-sputtering J. Advanced Materials, 2009, 21(5):593; US Patent no. 7758979). However, scandium is a very expensive material (Currently, $14,000 for a 4" sputtering target). Moreover, it would be desirable to surpass the $d_{33}$ coefficients obtained with scandium. The piezoelectric strain coefficient d is defined as the ratio of developed free strain to the applied electric field. Using a compact notation, the subscripts $d_{ij}$ imply that the electric displacement field is produced in the $i$ direction for an applied stress or force per unit area in the j direction, or equivalently a strain is produced according to j, when an electric field is applied in the i-direction. See Meitzler A. et al. IEEE Standard on Piezoelectricity. The institute of electrical and electronic engineers, 1988, 74p.

The sputtered $Al_{0.57}Sc_{0.43}N$ alloy has a concentration of scandium at the limit of a phase transition between the dominant structures of wurtzite AlN and the cubic structure of scandium nitride (ScN). This discovery has raised the possibility of creating other high $d_{ij}$ intrinsic piezoelectric alloys that are easy to manufacture for the MEMS industry. Simulations using density functional theory (DFT) based on the modern theory of electrical polarisation propose that for the $Al_{0.57}Sc_{0.43}N$ alloy two effects may explain the increase in piezoelectric $d_{ij}$ coefficient compared to a pure AlN film (Tasnadi, F et al. Origin of the anomalous Piezoelectric Response in Wurtzite ScAlN Alloys. Phys. Rev. Lett. 104137601 (2010) 4p). On the one hand, the lower electronegativity of Sc with respect to Al ensures that the electrons are more localized around nitrogen, which increases the alloy electrical polarization. In addition, the inclusion of Sc makes the crystal more easily deformable due to the competition between the types of chemical bonds in an alloy with a composition near the hexagonal wurtzite to cubic phase transition. Thus, less stress is required to produce the same electrical polarization. As a consequence of these two facts, the piezoelectric coefficients $d_{ij}$ are greater. The ionic radius of the alloying element also has an important impact on the piezoelectric activity. If this radius is too big, distortion of the crystal lattice does not allow the appropriate alignment of the atoms so the electric polarization is diminished. This factor is highlighted by comparing the results of simulations for $Al_{0.50}Sc_{0.50}N$ and $Al_{0.50}Y_{0.50}N$ alloys (Tholander C. et al. Volume matching condition to establish the enhanced piezoelectricity in ternary (Sc,Y)0.5 (Al,Ga,In)0.5 alloys. Physical Review B, 2013, 5p). Yttrium has a lower electronegativity than Sc , but its ionic radius (180pm) is larger than that of scandium (162pm), so the resulting large lattice distortions degrade the piezoelectric performance. The maximum $d_{33}$ coefficient is only 12.5pm/V. Similar effects are reported in the literature for aluminum nitride and tantalum nitride alloys (Liu H. et al. Enhancement of piezoelectric response of diluted Ta doped AlN. Applied Surface Science, 2009, 7p.) as well as a quaternary alloy, $Al_{0.65}Mg_{0.16}Zr_{0.18}N$. Currently the $Al_{0.57}Sc_{0.43}N$ alloy has the highest reported piezoelectric coefficients.

US patent no. 9,225,313 discloses the use of erbium (from the lanthanide series) and yttrium (from the transition metal group) doped aluminum nitride in the context of a bulk acoustic wave resonator. The described mechanism "of upsetting the stoechiometry" is vague and potentially misleading. The stoechiometry could equally be "upset" by including Ti or V atoms in the alloys without enhancement of the piezoelectric response. Alloys of AlTiN and AlVN have shown poor piezoelectric properties and alloying with a fraction of more than a few atomic percent of TiN or VN will lead to the loss of the wurtzite structure. See, for example, 1-Iborra, E. et al. Piezoelectric and electroacoustic properties of Ti-doped AlN thin films as a function of Ti content. IEEE International Ultrasonics Symposium Proceedings. 2012, 4p; and 2-Iborra, E. et al. Piezoelectric and electroacoustic properties of V-doped and Ta-doped AlN Thin Films. 2013 Joint UFFC, EFTF and PFM Symposium. 2013, 4p.

Alloying close to a phase transition to improve the piezoelectric properties is also used for perovskites. For example, the effect of instability close to a phase transition explains the very high piezoelectric coefficients of PZT ($PbZr_xTi_{1-x}O_3$). Budimir M. et al.Piezoelectric response and free-energy instability in the perovskite crystas BaTiO3, PbTiO3 and Pb(Zr,Ti)O3. Physical review, 2006, 6p.A value of x close to 0.5 for this alloy places this system in a morphotropic transition zone in the phase diagram. Two piezoelectric phases (tetragonal and rhombohedral) then coexist and compete. Nurturing a defect free and [0002] oriented growth in aluminum nitride is also a way to optimize the activity of piezoelectric aluminum nitride. This can be achieved by adding Cr (Luo J.T. et al. Influence of Cr-doping on microstructure and piezoelectric response). However, doping versus alloying is limited in its application by the rather low starting coefficients of pure aluminum nitride.

Finally it may be possible for aluminum nitride based alloys to show ferroelectric properties. This transformation has been observed in alloys based on another piezoelectric material, ZnO, which also has excellent piezoelectric properties and a wurtzite structure. Atoms of vanadium added in the crystal function as mobile ions can take up distinct positions in the lattice, which vary depending on the applied electric field, leading to high electrical polarization. However, ferroelectrics have a major disadvantage due to the fact that they cannot be used at high temperature and an alignment of the electric dipoles by a poling process is required. Even with the 500% increase in coefficients for alloys containing scandium, the coefficients are far from the ferroelectric ceramic piezoelectric coefficients, which can reach several hundred pm/V.

Summary of the Invention

Embodiments of the invention provide new piezoelectric alloys based on aluminum nitride and selected elements from the lanthanide series that have extremely low electronegativity, similar chemical properties to scandium-doped aluminum nitride, similar nitride structure, and, with the exception of gadolinium, a lower atomic radius than yttrium. Gadolinium has a similar atomic radius to yttrium. The alloys show promise as components of AlN based alloys for high performance piezoelectric devices, such as - piezoelectric accelerometers, pressure sensors and gyroscopes. The invention is based in part on the realization that electronegativity, size, and bonding play an important role in determining piezoelectric properties, and that the selected members of the lanthanide series show a similar effect to scandium. In selecting the elements, it is important to pay attention to the resulting resistivity and crystal structure of the alloy. The selected elements have low electronegativity and show a wurzite-like structure when their nitride is alloyed with AlN.

According to the present invention there is provided a piezoelectric thin film made of an alloy $Al_{(1-y)}X_yN$, where X is selected from the group consisting of: Yb, Ho, Dy, Tm, Lu, Tb, and Gd; and y is the fraction of the compound XN in the alloy. The fraction of XN preferably lies in the range 5% to 60%, and preferably at least 10%-60%. The thin piezoelectric film may have a thickness of 50 to 2500nm, and optionally 100 to 2500nm. High stress alloys generally require very thin films.

The group of elements: ytterbium (Yb), holmium (Ho), dysprosium (Dy), lutetium (Lu), Thulium (Tm), gadolinium (Gd) and terbium (Tb) from the lanthanide series are herein collectively referred to as SHREE (Selected Heavy Rare Earth Elements). The thin film may be deposited by reactive co-sputtering of a target of aluminum and a target of a SHREE element in a nitrogen atmosphere.

The thin film is optionally subjected to an intrinsic tensile stress induced during fabrication of preferably at least 200Mpa and up to about 1.5 Gpa, which will improve the piezoelectric properties. The intrinsic tensile stress has an approximately linear effect on the piezoelectric properties.

This effect also applies to AlN-scandium alloys. Accordingly in another aspect of the invention there is provided a piezoelectric thin film made of an alloy $Al_{(1-y)}Sc_yN$; where y is the atomic fraction of ScN, and which is subject to an intrinsic tensile stress of at least 200MPa.

It will be appreciated that stress and strain are closely interrelated. The impact of stress can also be viewed as the impact of strain. As an alternative to the stress values the intrinsic distortion of the film can equivalently be defined in terms of a tensile strain of 0.2 to 1.5%.

The optional tensile stress can be applied in the film planar direction to increase the piezoelectric performance of the thin film. The application of tensile stress on the system improves the piezoelectric performance. Density functional theory based simulations show that such thin films possess a piezoelectric coefficient $d_{33}$ higher than that of aluminum nitride. Indeed the $d_{33}$ coefficient found for $Al_{0.5}Dy_{0.5}N$ alloy is 18pm/V, an improvement of over 300% from the piezoelectric coefficient of the aluminum nitride. A tensile stress of 1GPa could increase this improvement to a projected 500% based on the results for scandium.

The results found for the other elements go from 12.5pm/V in the case of Gd to 18.3pm/V in the case of Dy. The application of a tensile stress in the case of Yb further improves the performance of the film.

The SHREE elements Yb, Ho, Dy, Lu, Tm, Tb, and Gd form chemical bonds with nitrogen in the same way as aluminum, which results in a solid solution without precipitates. The electronegativity of these elements is also smaller than for scandium so they form larger electric dipoles, resulting in higher proper piezoelectric $e_{33}$ constants (table 1), which is also important for the piezoelectric effect.

The resulting alloys are also more compliant in the physical sense than pure aluminum nitride, as can be seen by their lower stiffness $c_{33}$ constant compared to $Al_{0.5}Sc_{0.5}N$ (table1). In addition, the atomic radius of the SHREEs are lower or equal (in the case of gadolinium) to the radius of yttrium, which allows the retention of a certain alignment of the electric dipoles in the film. These effects lead to higher piezoelectric coefficients with respect to aluminum nitride.

The novel piezoelectric films of the invention are particular suitable for use in MEMS devices, such as accelerometers, pressure sensors, transducers, etc., where it is desired to convert a deflection into a voltage signal or vice versa.

In a further aspect the invention comprises a MEMS device based on a piezoelectric thin film made of an alloy $Al_{1-y}X_yN$, where X is selected from the group consisting of: Yb, Ho, Dy, Lu, Tm, Tb, and Gd; where y is the atomic fraction of XN.

In yet a further aspect the invention comprises a piezoelectric thin film alloy of $Al_{1-y}X_yN$, where X is selected from the group consisting of: Yb, Ho, Dy, Lu, Tm, Sc, Tb, and Gd; where y is the atomic fraction of XN, wherein the film is subjected to a tensile intrinsic strain of about 0.2 to 1.5%.

Brief Description of the Drawings

The invention will now be described in more detail, by way of example only, with reference to the accompanying drawings, in which:-

Figure 1 is a plot of the $d_{33}$ coefficient vs. tensile stress for pure AlN;

Figure 2 is a plot of the $d_{33}$ coefficient vs. tensile stress for $Al_{0.5}Sc_{0.5}N$;

Figure 3 shows a related 3x3x3 supercell, and the positioning of the corresponding atoms in a quasi random structure;

Figure 4 is a cross sectional view schematically illustrating a piezoelectric device;

Figure 5 is a schematic view of a co-reactive sputtering chamber; and

Figure 6 is a schematic cross section of a MEMS device containing a piezoelectric film in accordance with embodiments of the invention.

Detailed Description of the Preferred Embodiments

Embodiments of the invention provide new aluminum nitride (AlN) based thin film alloys incorporating the selected heavy rare earth elements (SHREEs), namely ytterbium gadolinium, dysprosium, holmium, thulium, terbium, and lutetium, that have higher piezoelectric $d_{ij}$ coefficients than pure aluminum nitride. This improvement can be enhanced by applying a tensile stress of preferably at least 200MPa and more preferably in the order of 1.0 GPa on the thin film. The results of DFT simulations show that these alloys present piezoelectric $d_{33}$ coefficients of up to 18 *pm/V,* more than three times the piezoelectric coefficient of aluminum nitride with no tensile stress applied. In addition, DFT simulations show that the addition of tensile stress on the thin film can potentially increase by 70% the piezoelectric coefficients of the alloys.

The DFT simulation is started by finding a proper special quasi random structure to represent an alloy and generating 4f electron in core pseudopotentials for the lanthanides with commonly available software. This structure is then stretched and relaxed with DFT simulation software for +-0, 1% of the c-axis lattice parameter for the fully relaxed system. The electric polarization and stress inside the structure is then calculated with Berry phase calculation for these relaxed structures and the $d_{33}$ coefficient is calculated from the equation:

$$d_{33} \approx e_{33}/c_{33} = \text{(difference in polarization)/(difference in stress)}.$$

This is a good approximation for high values of $d_{33}$. See Tasnadi, F et al. *supra,* the contents of which are herein incorporated by reference. As a verification of the model, the results for AlN and $Al_{0.5}Sc_{0.5}N$ have been reproduced.

The following table shows the results of DFT simulations for selected alloys.

Table 1: Simulation results for selected SHREE-nitride alloyed with AlN

| Alloy investigated | Calculated $d_{33}$ (pm/V) | Calculated $c_{33}$ (GPa) | Calculated $e_{33}$ (pC/m$^2$) | DFT effective band gap (eV) |
|---|---|---|---|---|
| $Al_{0.5}Gd_{0.5}N$ | 12.6 | 158.4 | 2.0 | 1.3 |
| $Al_{0.5}Dy0_{.5}N$ | 18.3 | 134.9 | 2.5 | 2 |
| $Al_{0.5}Ho_{0.5}N$ | 15.6 | 152.6 | 2.4 | 2.1 |
| $Al_{0.5}Tm_{0.5}N$ | 16.2 | 150.7 | 2.4 | 2.2 |

(continued)

| Alloy investigated | Calculated $d_{33}$ (pm/V) | Calculated $c_{33}$ (GPa) | Calculated $e_{33}$ (pC/m$^2$) | DFT effective band gap (eV) |
|---|---|---|---|---|
| $Al_{0.5}Yb_{0.5}N$ | 16.8 | 148.7 | 2.5 | 2.2 |
| $Al_{0.5}Lu_{0.5}N$ | 17.7 | 145.6 | 2.6 | 2 |

Simulations for terbium have not yet been completed, but similar results are expected based on its electronic configuration.

The bandgaps obtained in the DFT calculations are known to be underestimated. In practice, they are expected to be in the vicinity of 4eV. See Dixit H. et al. Electronic structure of transparent oxides with the Tran-Blaha modified Becke-Johnson potential. J. Phys.: Condens. Matter. 24 (2012) 205503 (9pp), the contents of which are herein incorporated by reference. The bandgap is significantly above zero, which is a necessary condition for high resistivity of the alloys.

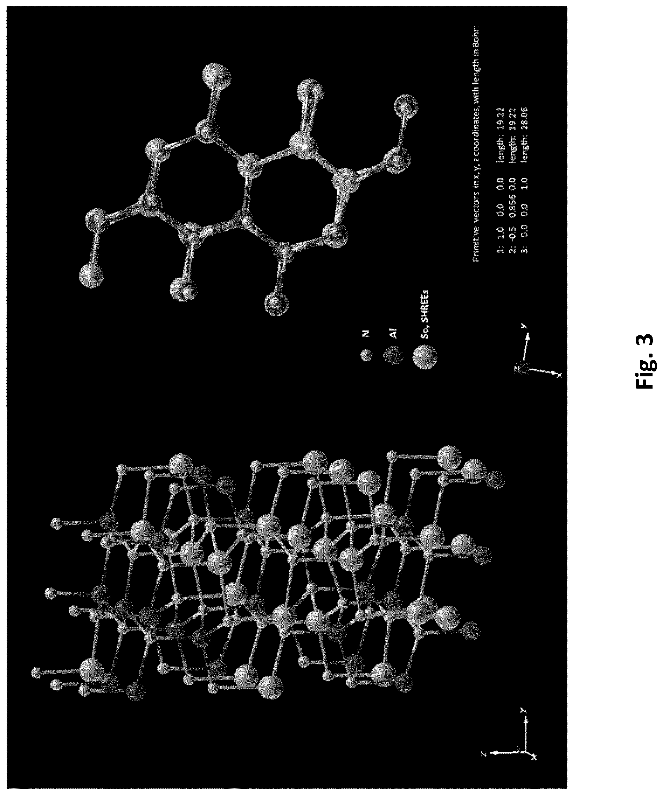

The output structure of the simulation has been examined to confirm a wurtzite structure. For example, Figure 3 shows a relaxed 3x3x3 supercell, and the positioning of the corresponding atoms in the special quasi random structure. In Figure 3, the larger gray spheres represent the SHREE atoms, the darker medium-sized spheres represent Al atoms, and the smaller gray spheres represent nitrogen atoms, as indicated in the figure.

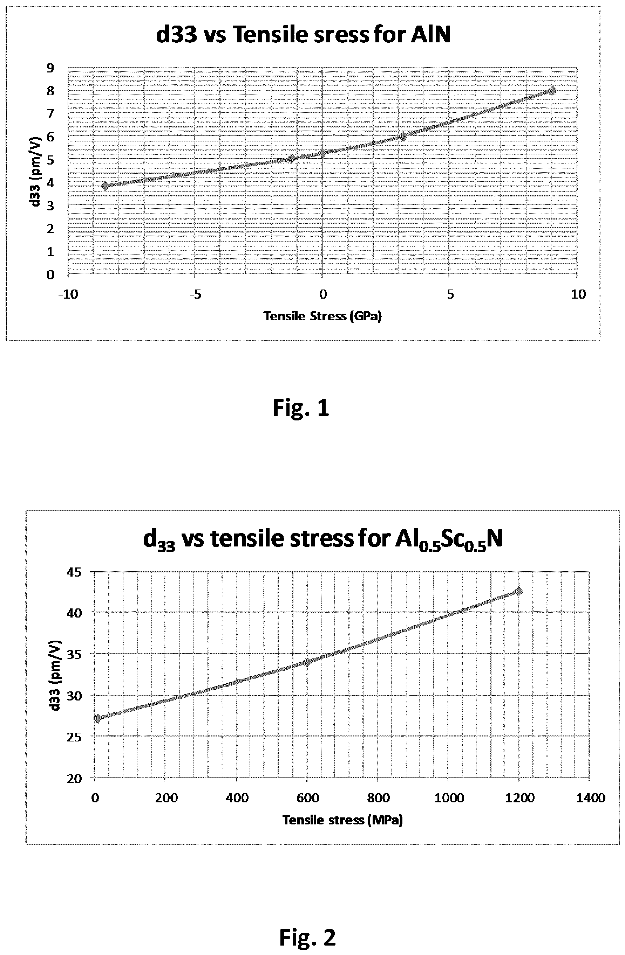

Figure 1 shows the effect of applying tensile stress to pure AlN. There is a gradual improvement in the $d_{33}$ coefficient as apparent from the following table.

Table 2

| Stress (GPa) | $d_{33}$ (pm/V) |
|---|---|
| 9.06 | 7.99 |
| 3.16 | 5.99 |
| 0 | 5.24 |
| -1.22 | 4.99 |
| -8.51 | 3.8 |

Figure 2 shows the effect of applying tensile stress to $Al_{0.5}Sc_{0.5}N$.

Table 3

| Stress (MPa) | $d_{33}$ (pm/V) |
|---|---|
| 8 | 27.1 |
| 600 | 33.9 |
| 1200 | 42.5 |

The effect of tensile stress is significantly greater than for pure AlN, but as previously noted scandium is an expensive material to work with. Nevertheless, these results show that existing scandium-based alloys can be improved by providing an intrinsic stress. The effect occurs almost immediately with increasing stress, but a practical lower limit is 200MPa. The applicants have demonstrated that certain elements in the lanthanide series exhibit a similar phenomenon. The following table shows the results for $Al_{0.5}Yb_{0.5}N$.

Table 4

| Stress (MPa) | $d_{33}$ (pm/V) |
|---|---|
| 0 | 16.7 |
| 1000 | 19.5 |

This shows that there is an improvement in the $d_{33}$ coefficient with tensile stress, although not as great as with scandium.

The following table shows the simulation results for lanthanum (La), which is a not member of the selected SHREE elements and lutetium (Lu). They were obtained for a smaller 2x2x2 supercell simulation domain, which tends to overestimate results by 28%.

Table 5

| | $d_{33}$ (pm/V) (2x2x2) | | $d_{33}$ (pm/V)(2x2x2) |
|---|---|---|---|
| $Al_{0.5}La_{0.5}N$ | 9.9 | $Al_{0.5}Lu_{0.5}N$ | 22.8 |

Lu has a full 4f shell electronic configuration that is much easier to handle in simulations. Simulations using 4f electrons in core pseudopotentials and the usual 4f electrons as valence pseudopotentials give piezoelectric coefficients of 23.2 pm/V and 22.8 pm/V respectively for a given 2x2x2 supercell simulation domain. The similarity of the results support the validity of our simulation method. The validity of the results is further supported by the strong correlation between the calculated SHREE-nitride lattice parameters and the experimental values.

The simulations for La show that not all lanthanides can be alloyed heavily and give significant increase in $d_{33}$. The results for Lanthanum are only marginally better than for pure AlN, and the configuration would not be stable if the alloy were fabricated. It would probably separate in cubic non-piezoelectric material phases.

A comparison of the results for $Al_{0.5}La_{0.5}N$ and $Al_{0.5}Lu_{0.5}N$ show the effect of change in structure. $Al_{0.5}Lu_{0.5}N$ remains almost wurtzite like (same structure as base AlN), whereas $Al_{0.5}La_{0.5}N$ does not.

The alloys in accordance with embodiments of the invention are manufactured generally in accordance with the techniques disclosed in US patent no. 7,758,979, the contents of which are herein incorporated by reference. However, the SHREE-based alloys should be less expensive to manufacture than Scandium-based materials. Scandium is extremely scarce and hard to refine.

Piezoelectric materials with larger $d_{33}$ piezoelectric coefficients are essential for advanced piezoelectric MEMS devices, such as sensors, resonators, piezoelectric accelerometers, and gyroscopes.

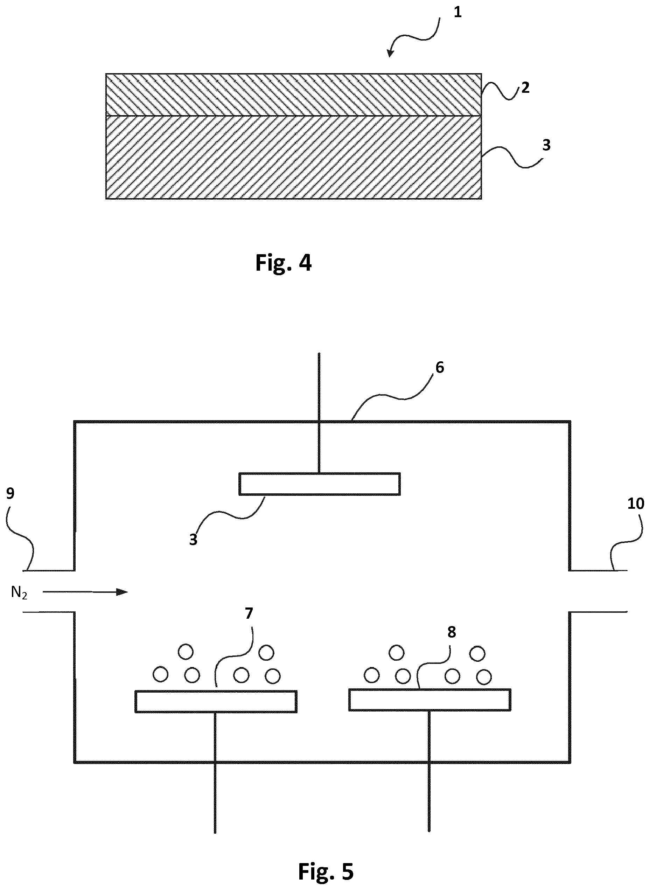

The piezoelectric device 1 shown in Figure 4 comprises a thin film 2 of $Al_{(1-y)}X_yN$, where X is selected from the group consisting of: Yb, Ho, Dy, Lu, Tm, Tb, and Gd; and y is the atomic fraction of XN deposited on a substrate 2. The material of the substrate 2 could, for example, be single-crystal silicon or the like, but other suitable materials may be employed such as saphire, molybdenum or platinum. Buffer layers (not shown) could also be incorporated between the substrate 3 and the film 2, to better control the properties of the film 2.

In order to manufacture the device in accordance with the invention, as shown in Figure 5, the temperature controlled substrate holder and substrate 3 is placed in a sputtering chamber 6 with two targets 7, 8, an inlet port 9 for the sputtering gas, and an outlet port 10. In this example, the sputtering gas is a mixture of nitrogen, which is the reactive gas, and argon, which helps the sputtering, although it will be appreciated that other mixtures could be employed. The first target 7 is aluminum, and the second target 8 is the SHREE element X, for example, ytterbium.

The Al atoms from the target 7 and the X atoms from the target 8 are deposited on the silicon substrate and react with the reactive gas, in this case nitrogen, to form the $Al_{(1-y)}X_yN$ film 2 on the substrate 1.

The tensile stress can be controlled by changing the deposition parameters during sputtering. For example, lower adatom mobility (lower substrate temperature) to control crystallite island growth can lead to induce tensile stress in polycrystalline films.

Stress can also be generated by using a templating substrate with a higher lattice parameter instead of a bulk substrate, for example, a silicon bulk substrate with an epitaxially grown buffer layer.

The piezoelectric alloys according to embodiments of the invention show an increase of up to 300% of the piezoelectric coefficient $d_{33}$ of the aluminum nitride following incorporation SHREE elements, such as ytterbium or gadolinium. This improvement can reach up to about 500% upon the application of a tensile stress of 1 GPa on the thin layer in the planar direction.

The alloys can also be made at reduced cost of manufacture compared to scandium-based alloys, which is a consequence of the lower price of the SHREE (except for Lu) targets when compared to a scandium target. For example, in the case of 4" diameter sputtering targets, the price of ytterbium and gadolinium targets is only of the order $1000 compared to $14,000 for a scandium target.

The current results are based on simulations. Although the methodology allows accuracy within a few % of the experimentalvalues, the microstructure can be optimized during the deposition steps.

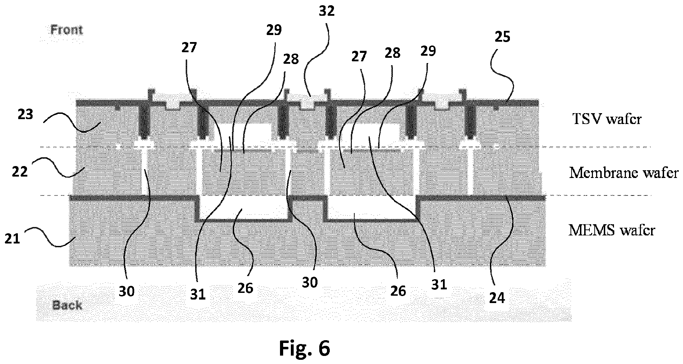

By way of example, a MEMS device in the form of an inertial sensor (accelerometer) is shown in Figure 6. This comprises three stacked silicon wafers, namely MEMS substrate wafer 21, membrane wafer 22, and TSV (Though Silicon Via) wafer 23.

Cavities 26 to contain inertial masses 27 are etched in the Si substrate wafer 21. The second Si wafer 22 is bonded to the first wafer 21, then ground and polished to form a thin silicon layer. The piezoelectric film 28 in accordance with embodiments of the invention and top electrode 29 are deposited and patterned, followed by anisotropic etching of vias 30 and silicon springs (not shown) to form the inertial mass 27.

Cavities 31 to contain the inertial masses 27 are prepared on the third Si wafer 23, which is bonded to the membrane wafer 22. The wafer 23 is ground and polished then AlCu contacts 32 are deposited on the third wafer 23.

In the presence of an acceleration the mechanical deformation of the piezoelectric film 28 produces a electrical signal. It will be appreciated that the actual layout (as seen from the top) of the device varies according to the intended application.

In at least one embodiment, the thickness of the film may lie in the range 50nm to 2500nm.

All references introduced above are herein incorporated by reference.

**Claims**

1. A piezoelectric thin film made of an alloy $Al_{(1-y)}X_yN$, where X is selected from the group consisting of: Yb, Ho, Dy, Lu, Tm, Tb and Gd; where y is the fraction of XN.

2. The piezoelectric thin of claim 1, wherein the fraction y lies in the range 5 to 60%.

3. The piezoelectric thin film of claim 1, wherein the thickness of the film is at least 50nm.

4. The piezoelectric thin film of claim 3, wherein the film is subjected to an intrinsic tensile stress of at least 200MPa to increase the piezoelectric coefficient.

5. The piezoelectric thin film of claim 4, wherein the film is subjected to an intrinsic tensile stress of about 1GPa.

6. The piezoelectric thin film of claim 5, wherein X is selected from the group consisting of: Yb and Gd.

7. A method of making a piezoelectric thin device comprising depositing on a substrate a thin film of $Al_{(1-y)}X_yN$, where XN is selected from the group consisting of: Yb, Ho, Dy, Lu, Tm, Tb, and Gd; and y is the fraction of XN by co-reactive sputtering using targets of Al and X.

8. The method of claim 7, wherein the substrate is silicon.

9. The method of claim 8, wherein the fraction y lies in the range 10 to 60%.

10. The method of claim 9, wherein the thickness of the film is at least 50nm.

11. The method of claim 11, comprising subjecting the thin film to an intrinsic tensile stress to increase the piezoelectric coefficient.

12. The method of claim 11, wherein the thin film is subjected to an intrinsic tensile stress of about 1GPa.

13. The method of claim 12, wherein X is Dy.

14. A piezoelectric device, comprising the thin film of claim 1 deposited on a substrate.

15. The piezoelectric device of claim 14, wherein the atomic percentage y lies in the range 10 to 60%.

16. The piezoelectric device of claim 14, wherein the thickness of the film is at least 50nm.

17. The piezoelectric device claim 16, wherein the film is subjected to a tensile stress of up to 1GPa.

18. The piezoelectric device of claim 17, which is a MEMS device.

19. A piezoelectric thin film made of an alloy $Al_{(1-y)}Sc_yN$; where y is the fraction of ScN, and which is subject to an intrinsic tensile stress of at least 200MPa.

20. A piezoelectric thin film as claimed in claim 19, which is $Al_{0.50}Sc_{0.50}N$.

21. A piezoelectric thin film made of an alloy $Al_{(1-y)}X_yN$, where X is selected from the group consisting of: Yb, Ho, Dy, Lu, Tm, Tb, Sc, and Gd; where y is the fraction of XN, wherein the film is subjected to an intrinsic strain of about of 0.2 to 1.5%.

22. A MEMS device comprising the piezoelectric thin film of claim 1.

23. A MEMS device comprising the piezoelectric thin film of claim 21.

**Fig. 1**

**Fig. 2**

N

Al

Sc, SHREEs

Primitive vectors in x, y, z coordinates, with length in Bohr:

1:  1.0   0.0    0.0    length: 19.22
2: -0.5   0.866  0.0    length: 19.22
3:  0.0   0.0    1.0    length: 28.06

**Fig. 3**

**Fig. 4**

**Fig. 5**

Fig. 6

Europäisches
Patentamt

European
Patent Office

Office européen
des brevets

# EUROPEAN SEARCH REPORT

Application Number

EP 17 16 0064

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/125203 A1 (CHOY JOHN [US] ET AL) 8 May 2014 (2014-05-08) <br> * page 2, paragraph 34 - page 3, paragraphs 34,39 * <br> * page 4, paragraph 41 - page 5, paragraph 51; table 1 * | 1-23 | INV. <br> C23C14/06 <br> C23C14/34 <br> H01L41/187 <br> H01L41/316 |
| X | US 2015/311046 A1 (YEH TANGSHIUN [US] ET AL) 29 October 2015 (2015-10-29) <br> * page 2, paragraph 18-20 - page 3, paragraphs 22,24 * <br> * page 4, paragraph 32 - page 5, paragraph 38 * <br> * page 7, paragraph 52 * | 1-23 | |
| A | US 2015/333727 A1 (MOULARD GILLES [DE] ET AL) 19 November 2015 (2015-11-19) <br> * page 1, paragraphs 11,13; claims 11,12,14,18 * | 1-23 | |

TECHNICAL FIELDS SEARCHED (IPC)

C23C
H01L

The present search report has been drawn up for all claims

| Place of search | Date of completion of the search | Examiner |
|---|---|---|
| The Hague | 25 July 2017 | Boussard, Nadège |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 16 0064

This annex lists the patent family members relating to the patent documents cited in the above-mentioned European search report.
The members are as contained in the European Patent Office EDP file on
The European Patent Office is in no way liable for these particulars which are merely given for the purpose of information.

25-07-2017

| Patent document cited in search report | | | Publication date | Patent family member(s) | | | Publication date |
|---|---|---|---|---|---|---|---|
| US 2014125203 | A1 | | 08-05-2014 | NONE | | | |
| US 2015311046 | A1 | | 29-10-2015 | NONE | | | |
| US 2015333727 | A1 | | 19-11-2015 | EP | 2936680 | A1 | 28-10-2015 |
| | | | | JP | 2016507939 | A | 10-03-2016 |
| | | | | US | 2015333727 | A1 | 19-11-2015 |
| | | | | WO | 2014094887 | A1 | 26-06-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7758979 B

- US 9225313 B

### Non-patent literature cited in the description

- **AKIYAMA, M et al.** Enhancement of Piezoelectric Response in Scandium Aluminum Nitride Alloy Thin Films Prepared by Dual Reactive Co-sputtering J. *Advanced Materials,* 2009, vol. 21 (5), 593
- **MEITZLER A. et al.** *IEEE Standard on Piezoelectricity. The institute of electrical and electronic engineers,* 1988, 74p
- **TASNADI, F et al.** Origin of the anomalous Piezoelectric Response in Wurtzite ScAIN Alloys. *Phys. Rev. Lett.,* 2010, vol. 104137601, 4p
- **THOLANDER C. et al.** Volume matching condition to establish the enhanced piezoelectricity in ternary (Sc,Y)0.5 (Al,Ga,In)0.5 alloys. *Physical Review B,* 2013, 5p
- **LIU H. et al.** Enhancement of piezoelectric response of diluted Ta doped AIN. *Applied Surface Science,* 2009, 7p
- **IBORRA, E. et al.** Piezoelectric and electroacoustic properties of Ti-doped AIN thin films as a function of Ti content. *IEEE International Ultrasonics Symposium Proceedings,* 2012, 4p
- **IBORRA, E. et al.** Piezoelectric and electroacoustic properties of V-doped and Ta-doped AIN Thin Films. *2013 Joint UFFC, EFTF and PFM Symposium,* 2013, 4p
- **BUDIMIR M. et al.** Piezoelectric response and free-energy instability in the perovskite crystas BaTiO3, PbTiO3 and Pb(Zr,Ti)O. *Physical review,* 2006, 6p
- **DIXIT H. et al.** Electronic structure of transparent oxides with the Tran-Blaha modified Becke-Johnson potential. *J. Phys.: Condens. Matter.,* 2012, vol. 24 (205503), 9pp